# EUROPEAN PATENT APPLICATION

(11) **EP 2 159 827 A2**
(43) Date of publication of application: **03.03.2010**
(21) Application number: 09168544.6
(22) Date of filing: 25.08.2009
(51) Int. Cl.: H01L 21/261, H01L 21/322, C30B 15/00, C30B 29/06, H01L 21/331, H01L 29/739

(54) **Silicon wafer and method for producing the same**

(30) Priority: 28.08.2008 JP 2008220049
(71) Applicant: SUMCO CORPORATION, Minato-ku Tokyo 105-8634 (JP)
(72) Inventor: Umeno, Shigeru, Tokyo 105-8634 (JP); Nishimoto, Manabu, Tokyo 105-8634 (JP); Hourai, Masataka, Tokyo 105-8634 (JP)
(74) Representative: Cabinet Plasseraud

(57) **Abstract**

A silicon wafer is produced through the steps of forming a silicon ingot by a CZ method with an interstitial oxygen concentration of not more than 7.0x10¹⁷ atoms/cm³, slicing a wafer from the silicon ingot after doping the silicon ingot with phosphorus, forming a polysilicon layer or a strained layer on one main surface of the wafer, mirror polishing the other main surface of the wafer, and performing a heat treatment for the wafer in a non-oxidizing atmosphere.

## Description

### BACKGROUND OF THE INVENTION

### 1. Field of the Invention

The present invention relates generally to a silicon wafer and a method for producing the same. Although not limited, the present invention relates more specifically to a silicon wafer which is formed through a Czochralski method (hereinafter referred also to as CZ method) and is suitably used as a substrate for an insulated gate bipolar transistor (hereinafter referred also to as IGBT), and to a method for producing the silicon wafer.

### 2. Description of the Related Art

An insulated gate bipolar transistor (IGBT) has a structure including a MOSFET provided with a PN junction for hole injection. In the structure, a gate and an emitter are formed on a front surface side of an n⁻ type silicon layer with high resistivity, and a collector is formed on the back surface side thereof via the PN junction.

The IGBT is a device in which an electric current between the collector and the emitter is controlled by an electric voltage applied to the gate being provided via a silicon oxide film. Due to the hole injection from the collector to the n⁻ type silicon layer positioned between the gate and the emitter side and the collector side, the IGBT has features that an on-resistance may be reduced and that it is not easily destroyed even if a high electric current flows therethrough.

The IGBT controls an electric current by the gate provided via the oxide film, as described above, it is accordingly desirable for the gate oxide film to be free from defects. In addition, since the electric current flows between the emitter on the front surface of the device and the collector on the back surface, defects in a wafer have a large influence on the properties of the IGBT. Therefore, in the prior art, an epitaxial layer of an epitaxial wafer or a silicon wafer formed through a FZ method has been used as a substrate for the IGBT.

However, the n⁻ type silicon layer for providing an IGBT with high breakdown voltage is required to have a thickness of approximately 100 µm. In order to realize such a thickness by means of the epitaxial layer, a long time is required for an epitaxial growth process, and therefore the problem is that a significant increase in production cost cannot be avoided.

On the other hand, in the case of forming a silicon wafer through the FZ method, the amount of impurities contaminated during a production process is small, and therefore it is possible to obtain a wafer with relatively less defects compared to the case through the CZ method. However, the problems are that it is difficult to obtain a wafer having large diameter through the FZ method and that the FZ method is not appropriate for mass production.

Meanwhile, silicon wafers formed through the CZ method include defects caused from microscopic voids of 0.1 to 0.3 µm in size. If such defects are exposed to the surface of a wafer, the defects form pits on the wafer surface. These defects are generally called as COP (Crystal Originated Particle). It has been impossible to use a wafer having COPs as it stands as a wafer for an IGBT.

Considering the above, as described in Patent Document 1, a method for producing a wafer has been developed, in which the number of COPs is reduced by performing a heat treatment on a wafer obtained through the CZ method.

In addition, as described in Patent Document 2, another method for producing a wafer has been also developed, in which COPs included in a wafer with an oxygen concentration of not more than 7x10¹⁷ atoms/cm³ are eliminated by performing a heat treatment on the wafer in an oxidizing atmosphere, as well as polishing the wafer and removing residual COPs existing in the vicinity of the surface of the wafer after the heat treatment.

Patent Document 1 : International Publication WO2004/073057 pamphlet
Patent Document 2 : Japanese Unexamined Patent Publication No. 2006-344823

### SUMMARY OF THE INVENTION

The CZ method enables to produce easily a wafer having large diameter, and there has been realized mass production of wafers with diameter of 300 mm. Therefore, the CZ method is suitable for obtaining a wafer to be used as a substrate for LSIs. However, a wafer obtained through the CZ method has not been used as a substrate for an IGBT because of the following reasons.

The first reason is a poor yield of GOI (Gate Oxide Integrity). That is, in a wafer obtained through the CZ method, excess vacancies are aggregated during the growth of a single crystal to result COPs as void defects of 0.1 to 0.3 µm in size. If surface pits formed by the exposure of COPs on the wafer surface or COPs existing in the vicinity of the wafer surface are captured into the oxide film during a thermal oxidation process, GOI property deteriorates.

The second reason is that the existence of oxygen donors causes lower resistivity. A silicon wafer obtained through the CZ method includes excess oxygen in the order of 1x10¹⁸ atoms/cm³ (Fourier transform infrared spectroscopy ASTM F-121). Therefore, in the case of being processed through a lower temperature heat treatment of approximately 450°C, oxygen donors are caused to occur and the resistivity of a substrate is decreased, and as a result, the breakdown voltage between the collector and the emitter becomes lower.

The third reason is the occurrence of oxygen precipitates. As described above, a silicon wafer obtained through the CZ method generally includes oxygen in the order of 1x10¹⁸ atoms/cm³. Accordingly, during a heat treatment required in a device producing process, excess oxygen precipitates as SiO₂, thereby causing a leakage between the collector and the emitter.

The fourth reason is a poor homogeneity in resistivity. Resistivity of a silicon wafer obtained through the CZ method is controllable by varying the amount of dopant to be doped in a polycrystalline silicon. However, because of a small segregation coefficient of phosphorus, which is an element used in the substrate for an IGBT, concentration of phosphorus varies significantly in the longitudinal direction of a single crystal ingot. Therefore, wafers having a specific resistivity can be obtained only from a limited portion of the single crystal ingot.

The technique disclosed in Patent Document 1 enables elimination of COPs, which are the factors deteriorating the GOI property. Therefore, the technique may be applicable as a method for producing silicon wafers for IGBT. However, even if an oxygen concentration required for enabling the elimination of COPs, in the case of the oxygen concentration is high, the above-described problems, such as the deterioration in the breakdown voltage between the collector and the emitter by occurrence of oxygen donors, and the leakage between the collector and the emitter by the formation of excess oxygen precipitates, are caused.

The technique disclosed in Patent Document 2 enables elimination of COPs, which are the factors deteriorating the GOI property, and allows to avoid the deterioration in the breakdown voltage between the collector and the emitter caused from the oxygen donors and the leakage between the collector and the emitter caused from the oxygen precipitates. Therefore, the technique may be applicable as a method for producing silicon wafers for IGBT. However, according to the method, there is a high possibility that wafers be contaminated through a heat treatment with high temperature, because the method includes a step of etching wafers for releasing a machining strain after slicing wafers from a single crystal, and the heat treatment should be performed after the etching and therefore with a relatively rough cleansed condition. In order to avoid the contamination, the production process of wafers after the etching is required to have a cleansing process with maximum cleansing level. Such high level cleansing is, generally in a production process of wafers, performed for wafers after being mirror polished as a final stage cleansing. Therefore, a single purpose cleansing equipment is required to be introduced to the production process of wafers in order to perform such high level cleansing for wafers with a relatively rough cleansed condition after etching.

The object of the present invention is, therefore, to provide a silicon wafer which is formed through a CZ method and is suitably used as a substrate for an IGBT and a method for producing the same.

According to an aspect of the present invention, there is provided a method for producing a silicon wafer. The method comprises forming, by a Czochralski method (CZ method), a silicon ingot having an interstitial oxygen concentration of not more than 7.0x10¹⁷ atoms/cm³, slicing a wafer from the silicon ingot after doping the silicon ingot with phosphorus, forming a polysilicon layer or a strained layer on one main surface of the wafer, polishing the other main surface of the wafer, and performing a heat treatment for the wafer in a non-oxidizing atmosphere.

According to another aspect of the present invention, there is provided a silicon wafer. The silicon wafer has an oxygen concentration of not more than 7.0x10¹⁷ atoms/cm³ and is doped with phosphorus, that the silicon wafer includes light scattering particles with diameters of not less than 0.09 µm detectable by a light scattering method and the light scattering particles have a number of not more than 0.1 piece/cm² at a surface of the wafer after a heat treatment in a non-oxidizing atmosphere as well as at a surface of the wafer after a heat treatment and polishing of 7 µm, and that the silicon wafer has a polysilicon layer or a strained layer formed on one main surface of the wafer.

The present invention enables to provide a silicon wafer which is formed through a CZ method and is suitably used as a substrate for an IGBT.

### BRIEF DESCRIPTION OF THE DRAWING

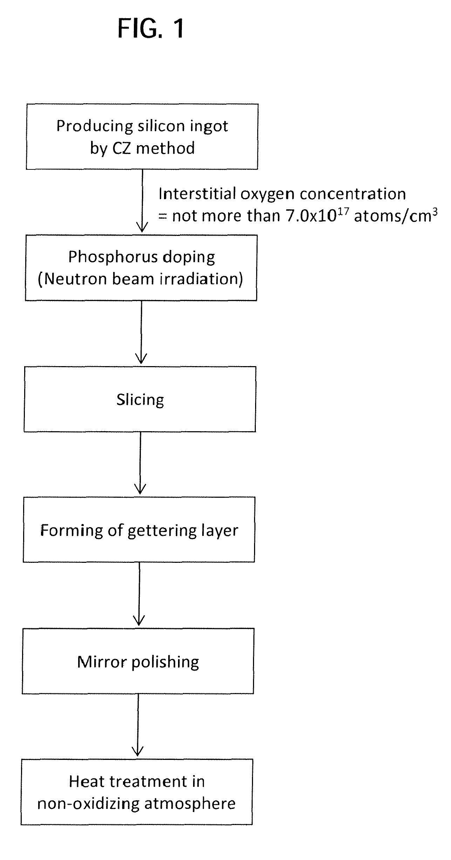

Figure 1 is a flow chart illustrating a method for producing a silicon wafer according to the embodiment of the present invention.

### DESCRIPTION OF THE PREFERRED EMBODIMENTS

Hereinafter, a method for producing a silicon wafer for an IGBT according to the embodiment of the present invention will be described in detail with reference to the drawing. Figure 1 is a flow chart illustrating the method for producing a silicon wafer according to the present embodiment.

The method for producing a silicon wafer according to the present embodiment includes the following stages. A silicon ingot is grown by the Czochralski method to have an interstitial oxygen concentration of not more than 7.0x10¹⁷ atoms/cm³ (ASTM F-121). Next, after doping phosphorus into the silicon ingot by neutron irradiation, wafers are sliced from the ingot. Then, as a gettering layer, a polysilicon layer or a strained layer is formed on one main surface of each wafer, and the other main surface of the wafer is mirror polished. Finally, the wafers are heat treated in a non-oxidizing atmosphere.

Hereinafter, each stage of the method will be described in detail.

### «Production of Ingot»

A silicon ingot having an interstitial oxygen concentration [Oi] of not more than 7.0x10¹⁷ atoms/cm³ may be produced by the CZ method.

Production of the silicon ingot by the CZ method is performed in the following steps. Firstly, blocks of polycrystalline silicon are put into a quartz crucible of a pulling apparatus. A silicon melt is obtained by heating the blocks of polycrystalline silicon in an argon atmosphere. Next, a seed crystal is immersed in the silicon melt and then is gradually pulled up while rotating the seed crystal and the quartz crucible, thereby a single crystal is grown under the seed crystal.

As an example of production condition in this case, there may be set a pulling condition for the single crystal growth that a ratio V/G of a growth rate V (mm/minute) of the single crystal and a temperature gradient G (°C/mm) between a melting point and 1350°C during the single crystal growth is controlled to be approximately in a range of 0.22 to 0.27. There may be also provided an example of additional conditions of controlling the rotation speed of the quartz crucible to be 0.05 to 0.5 rpm, pressure of the argon atmosphere to be 30 Torr, and magnetic field strength to be 3500 Gauss.

By controlling the interstitial oxygen concentration of the silicon ingot to be not more than 7x10¹⁷ atoms/cm³, generation of oxygen donors during a production process of an IGBT can be inhibited. An interstitial oxygen concentration exceeding 7x10¹⁷ atoms/cm³ is not preferable, because at such a concentration, oxygen donors occur during the production process of the IGBT, and change the properties of the IGBT.

### «Phosphorus Doping»

Next, the silicon ingot which has been produced by the above-described method is subjected to neutron beam irradiation. By the neutron beam irradiation, a certain amount of the silicon atoms are transformed to phosphorus atoms, thereby the silicon ingot which is homogeneously doped with phosphorus and has homogeneous resistivity is obtained.

When an n type silicon single crystal is doped with phosphorus by a method of adding phosphorus to a silicon melt from which the silicon single crystal is pulled, the resistivity varies along a pulling direction of the ingot. The variation of the resistivity causes changes in the properties of the IGBTs. Therefore, in the present embodiment, there is adopted a neutron irradiation method which allows the concentration of dopant to be homogeneous in an ingot as a whole.

For example, conditions for the neutron beam irradiation may be set such that at a position at which the flux of neutron beam is 3.0x10¹² neutrons/cm²/s, an ingot is irradiated with the neutrons for approximately 80 hours while being rotated at a rotation speed of approximately 2 rpm. Thus, after the neutron irradiation, the resistivity of the silicon ingot becomes approximately 48 Ω·cm to 52 Ω·cm.

### «Slicing, Forming of Gettering Layer, Mirror Polishing, and so forth»

Next, wafers are sliced from the silicon ingot. Where necessary, each wafer is subjected to lapping, etching, or the like. Subsequently, a gettering layer is formed on one main surface of the wafer. The gettering layer is provided as a strained layer obtained by a sand blasting method or the like, or provided alternatively as a polysilicon film. Then, after mirror polishing the other main surface of the wafer, contaminating substances are removed from the wafer by performing a cleansing.

### «Heat Treatment in Non-oxidizing Atmosphere»

Next, the wafer is heat treated in a non-oxidizing atmosphere. As the non-oxidizing atmosphere, an argon atmosphere or a hydrogen atmosphere is preferable. Heat treatment for the wafer in an argon atmosphere or a hydrogen atmosphere allows COPs in the vicinity of the surface of the wafer to disappear. In addition, since lower temperature of the heat treatment requires a long time for COPs to disappear, thereby decreasing a productivity, whereas higher temperature encourages the occurrence of slip dislocations, and therefore an anneal temperature is preferable in the range of 1100 to 1250°C.

### «Effect of the Embodiments»

According to the above-described method for producing silicon wafers, a silicon ingot having an interstitial oxygen concentration of not more than 7x10¹⁷ atoms/cm³ is used. Therefore, the method allows to avoid the leakage between the collector and the emitter caused from the oxygen precipitates (BMD; Bulk Micro Defect) which are generated in a production process of an IGBT, and to avoid the deterioration in the breakdown voltage between the collector and the emitter caused from the formation of the oxygen donors.

In addition, according to the present embodiment, wafers are subjected to a heat treatment in a non-oxidizing atmosphere. Therefore, the method allows COPs at the vicinity of wafer surface (to be a gate region of IGBT) to disappear, thereby improving a yield of GOI.

In addition, according to the present embodiment, by irradiating neutrons to the silicon ingot, it is possible to transform a certain amount of the silicon atoms into phosphorus atoms, thereby realizing a homogeneous doping of phosphorus in the silicon ingot from which wafers having a constant resistivity can be obtained.

In addition, according to the present embodiment, wafers are subjected to cleansing with high cleansing level after being mirror polished, and thereafter subjected to a heat treatment with high temperature. Therefore, it becomes possible to avoid a contamination through the heat treatment, and a single purpose cleansing equipment is not required to be introduced in order to perform such high level cleansing for wafers after etching.

In silicon wafers obtained by the method, COPs exist scarcely in a part of each wafer to be a gate region of an IGBT. In addition, variation of resistivity is reduced within a surface of each wafer, and among the different wafers sliced from the same ingot. Moreover, in the production process of an IGBT, generation of BMDs and fluctuation of resistivity are scarcely caused. Therefore, it is possible to use a wafer obtained by the present embodiment as a suitable substrate for an insulated gate bipolar transistor (IGBT).

In addition, since the wafer has a gettering layer such as a polysilicon layer or a strained layer, which is formed on one main surface of the wafer, it is possible to eliminate heavy metal contamination in the production process of an IGBT.

### EXAMPLES

### «Common Conditions for Examples 1 and 2 and Comparative Example 1»

Firstly, silicon ingots with various interstitial oxygen concentrations were produced by the CZ method for Examples 1 and 2 and Comparative Example 1.

More specifically, each ingot was prepared by the following steps. Firstly, blocks of polycrystalline silicon were put into a quartz crucible, and a silicon melt was obtained by heating the blocks of polycrystalline silicon in an argon atmosphere. Next, a seed crystal was immersed in the silicon melt and was gradually pulled up while rotating the seed crystal and the crucible, thereby a single crystal was grown under the seed crystal. At that time, a ratio V/G of a growth rate V (mm/minute) of the single crystal and a temperature gradient G (°C/mm) between a melting point and 1350°C during the single crystal growth was set to be approximately 0.27.

Thus, single crystalline silicon ingots were produced.

The interstitial oxygen concentration for each silicon ingot was controlled by adjusting the rotation speed of the quartz crucible and the pressure of the argon atmosphere. The oxygen concentration may be reduced by lowering the rotation speed of the quartz crucible, or by reducing a pressure of the argon atmosphere. In addition, by adopting a MCZ method (magnetic field applied Czochralski method), it becomes more easy to produce a silicon ingot with low oxygen concentration. Thus, silicon ingots having an interstitial oxygen concentration within a range of 3x10¹⁷ atoms/cm³ to 11x10¹⁷ atoms/cm³ were produced.

Next, the silicon ingots described above were doped with phosphorus by neutron beam irradiation. The neutron beam irradiation was continued during 80 hours under the flux condition of 3.0x10¹² neutrons/cm²/s (resultant resistivity being approximately 50Ω·cm).

After that, wafers were sliced from the silicon ingots. The sliced wafers were subjected to surface treatment such as lapping, etching, mirror polishing, and cleansing. When a density of light scattering particles on the surface of each wafer was measured, the density was approximately 2 pieces/cm². There is known in general that a large part of the light scattering particles detected on a mirror polished wafer is from COPs. Therefore, the above measurement result may be interpreted as that COPs of 2 pieces/cm² existed on the surface of the wafer. It is to be noted that the measurement of the density of light scattering particles was performed by using SP1 provided by KLA Tencol Corporation and by counting the number of light scattering particles with diameters of not less than 0.09 µm.

### «Example 1»

In order to eliminate COPs in the vicinity of the surface of a wafer, the wafers described above were heat treated under the conditions of the heat treatment atmosphere of 100% argon, the holding temperature of 1200°C, and the holding time of one hour. Thus, silicon wafers having various interstitial oxygen concentrations were obtained with each diameter of 200 mm.

With respect to each wafer, the density of light scattering particles was measured for each of two status, one for a surface of the silicon wafer after the heat treatment, and the other for a surface of the same after re-polishing of 7 µm depth. The measured values of density of light scattering particles were in a range of approximately 0.05 to 0.07 piece/cm² in no accordance with the oxygen concentration nor presence of re-polishing.

Next, yields of GOI were evaluated with conditions of gate oxide film thickness of 25 nm, electrode area of 8 mm², and criteria electric field intensity of 11 MV/cm. As a result, the yields of GOI were not less than 95%.

Then, oxygen precipitates (BMDs) were evaluated by using an infrared tomography method. In the infrared tomography method, it is difficult to discriminate COPs and BMDs because these are equally detected as light scattering particles. Accordingly, the evaluation of BMDs was performed as follows. After defining light scattering particles density "A" ( = COPs density) as being light scattering particles density before the heat treatment for eliminating COPs in the vicinity of the surface, and light scattering particles density "B" ( = COPs density and BMDs density) as being light scattering particles density after a heat treatment simulating an IGBT production process (the maximum temperature of 1150°C and the minimum temperature of 450°C), which is performed after the heat treatment for eliminating COPs in the vicinity of the surface, a ratio B/A was calculated and it was determined that the oxygen precipitation had occurred (BMDs had been generated) in the case of the ratio B/A being more than 1. As a result, it has been found that the oxygen precipitation occurs when the oxygen concentration exceeds 7x10¹⁷ atoms/cm³.

Next, changes in resistivity by the heat treatment simulating an IGBT production process (the maximum temperature of 1150°C and the minimum temperature of 450°C) were measured by using a four-point probe method. As a result, it has been found that the changes in resistivity exceed 5% when the oxygen concentration exceeds 7x10¹⁷ atoms/cm³.

Now, considering a resistivity specification of wafers for IGBT, a distribution of resistivity on wafer surface, fluctuation among wafer lots, and so forth, the changes in resistivity caused from oxygen donors must be suppressed within 5%. Therefore, from the aspects of the oxygen precipitation and the changes in resistivity, the upper limit of oxygen concentration is 7x10¹⁷ atoms/cm³.

### «Example 2»

Under the same conditions as Example 1 excepting that 100% hydrogen atmosphere was adopted as the heat treatment atmosphere in place of 100% argon atmosphere, the heat treatment was performed in order to eliminate COPs in the vicinity of the wafer surface. Then, same evaluations as Example 1 were performed.

With respect to each wafer, the density of light scattering particles was measured on a surface of the silicon wafer after the heat treatment and on a surface of the same after re-polishing of 7 µm depth. The measured values of density of light scattering particles were in a range of approximately 0.05 to 0.07 piece/cm² in no accordance with the oxygen concentration nor presence of re-polishing.

In addition, the yields of GOI were not less than 95%.

Regarding the oxygen precipitates (BMDs), it has been found that the oxygen precipitation occurs when the oxygen concentration exceeds 7.0x10¹⁷ atoms/cm³.

Regarding changes in resistivity by means of the four-point probe method, it has been found that the changes in resistivity exceed 5% when the oxygen concentration exceeds 7x10¹⁷ atoms/cm³. Therefore, from the aspects of the oxygen precipitation and the changes in resistivity, the upper limit of oxygen concentration is 7x10¹⁷ atoms/cm³.

### «Comparative Example 1»

Under the same conditions as Example 1 excepting that an oxygen atmosphere was adopted as the heat treatment atmosphere in place of 100% argon atmosphere or 100% hydrogen atmosphere, the heat treatment was performed in order to eliminate COPs in the vicinity of the wafer surface. Then, same evaluations as Example 1 were performed.

As a result, it has been found that COPs in the vicinity of the wafer surface remain (1.8 to 2.0 pieces/cm²), and the yields of GOI are poor (15 to 23%).

## Claims

1. A method for producing a silicon wafer, comprising:
forming a silicon ingot by a Czochralski method (CZ method), the silicon ingot having an interstitial oxygen concentration of not more than 7.0x10¹⁷ atoms/cm³;
doping the silicon ingot with phosphorus;
slicing a wafer from the silicon ingot;
forming a polysilicon layer or a strained layer on one main surface of the wafer;
mirror polishing the other main surface of the wafer; and
performing a heat treatment for the wafer in a non-oxidizing atmosphere.

2. The method for producing a silicon wafer as set forth in claim 1, wherein
the doping with phosphorus is performed by a neutron irradiation.

3. The method for producing a silicon wafer as set forth in claim 1, wherein
the heat treatment is performed in an argon atmosphere or a hydrogen atmosphere and at a temperature of 1100 to 1250°C.

4. The method for producing a silicon wafer as set forth in claim 1, wherein
a pulling condition for a single crystal growth is set in the Czochralski method, the pulling condition including a ratio V/G of a growth rate V (mm/minute) of the single crystal and a temperature gradient G (°C/mm) between a melting point and 1354°C during the single crystal growth, the ratio V/G being in a range of 0.18 to 0.24.

5. The method for producing a silicon wafer as set forth in claim 1, wherein
the silicon wafer is a wafer as a substrate for IGBT.

6. A silicon wafer comprising:
a silicon wafer having an oxygen concentration of not more than 7.0x10¹⁷ atoms/cm³;
the silicon wafer being doped with phosphorus;
the silicon wafer including light scattering particles with diameters of not less than 0.09 µm detectable by a light scattering method, the light scattering particles having a number of not more than 0.1 piece/cm² at a surface of the wafer after a heat treatment in a non-oxidizing atmosphere as well as at a surface of the wafer after a heat treatment and polishing of 7 µm; and
the silicon wafer having a polysilicon layer or a strained layer formed on one main surface of the wafer.

7. The silicon wafer as set forth in claim 6, wherein
the silicon wafer is a wafer as a substrate for IGBT.
